# EUROPEAN PATENT SPECIFICATION

(11) **EP 3 667 813 B1**
(45) Date of publication and mention of the grant of the patent: **29.11.2023**
(21) Application number: 18211440.5
(22) Date of filing: 10.12.2018
(51) Int. Cl.: H01Q 19/06, H01Q 15/23, H01Q 15/08, H01Q 23/00, H01Q 1/22, H01Q 1/24, H01Q 1/32, H01L 23/66

(54) **RADAR SENSOR WITH INTEGRATED ANTENNA AND FOCUSSING LENS**
RADARSENSOR MIT INTEGRIERTER ANTENNE UND FOKUSSIERENDER LINSE
CAPTEUR RADAR AVEC ANTENNE INTÉGRÉE ET LENTILLE DE FOCALISATION

(43) Date of publication of application: 17.06.2020
(73) Proprietor: indie Semiconductor FFO GmbH, 15236 Frankfurt (Oder) (DE)
(72) Inventor: WINKLER, Wolfgang, 15234 Frankfurt (Oder) (DE); GENSCHOW, Dieter, 15378 Rüdersdorf (DE)
(74) Representative: Maiwald GmbH

(56) References cited:
- DE-B3-102016 120 665
- US-A1- 2005 093 738
- US-A1- 2014 077 995
- US-A1- 2015 280 327
- US-A1- 2016 200 276
- US-A1- 2016 352 437
- US-B1- 6 590 544

## Description

### Technical field

The invention relates to the technical field of radar sensors and communication devices. More particularly, the invention relates to a dielectric lens, a radar sensor comprising a dielectric lens, a transmitter, configured for a mobile communications network, comprising a dielectric lens and to uses of a dielectric lens.

### Technical background

Radar sensors can be used to determine a distance of an object. A radar sensor may for example be used for filling level determination.

With the rising demand for general purpose miniaturized radar sensors with low cost and low power consumption, the construction of the lens and also the so-called side-lobe performance is an important factor.

US 2014/007995 A1 describes an electronically beam-steerable antenna device comprising a dielectric lens having at least one flat surface, a high-frequency dielectric board, a plurality of at least one primary antenna element with at least one transmission line formed on the high-frequency dielectric board and a switching network electrically connected to the plurality of at least one primary antenna element and at least one transmission line.

US 6,590,544 B1 describes a dielectric lens assembly for a feed antenna, including a dielectric extension on a hemispherical dielectric lens.

US 2005/0093738 A1 describes a radar sensor module suitable for miniaturization and reduction in costs, integrated into a one chip MMIC.

DE 10 2016 120 665 B3 describes a radar sensor unit with a high-frequency antenna and a lens.

US 2016/0200276 A1 describes a radar sensing of vehicle occupancy using a radar sensor assistant comprising an antenna system, at least one sensor and processing circuitry.

US 2016/0352437 A1 describes a fill level anthropology determination using a fill level measurement device with an antenna apparatus and a motor configured to rotate the antenna about an axis of rotation.

US 2015/0280327 A1 describes a radar antenna system including a chip, a reflector, and an antenna. The reflector is disposed on a surface of the chip.

### Summary

It may be seen as an object of the invention to provide for efficient focusing of a radar beam.

The object is solved by the subject-matter of the independent claims. Further embodiments are set forth in the dependent claims and the following description.

A first aspect relates to a dielectric lens, configured to focus electromagnetic radiation generated and emitted by a chip which comprises a radiating device, such as, for example, a planar antenna or an array of planar antennas. The dielectric lens comprises a lens body with a top portion and a bottom portion. The top portion is configured to focus electromagnetic main lobe radiation emitted by the chip. The bottom portion has a recess which is adapted to the size of the chip and configured to receive the chip or the chip together with chip-package.

According to an embodiment, the bottom portion of the lens body comprises a mirror arranged around the recess and configured to focus or at least reflect electromagnetic side-lobe radiation emitted by the chip.

For example, the mirror has a conical surface with an angle of about 45° to the longitudinal axis of the dielectric lens. The angle may also be smaller or bigger than that, for example around 45 or 60° or around 40 or 35°.

The mirror may also be shaped in form of a parabolic or hyperbolic or elliptical surface, to increase the focusing effect of the side-lobe radiation.

By providing a mirror, side-lobe radiation can be redirected towards the object to be observed, thus increasing gain.

According to another embodiment, the mirror comprises a metal layer on the surface of the mirror, to increase reflectivity.

According to another embodiment, the recess of the dielectric lens comprises slanting side-walls.

According to another embodiment, the body of the lens has a rotational symmetry.

The dielectric lens further comprises the chip, wherein the dielectric lens is placed on top of the chip and the recess of the lens encloses the chip.

The dielectric lens is glued to the chip with non-conducting glue.

According to another embodiment, the dielectric lens is fixed to the chip by a clip mechanism.

Another aspect of the invention relates to a radar sensor which comprises the above and below described dielectric lens.

A further aspect of the invention relates to a transmitter, a receiver or a transceiver, configured for a mobile communications network, comprising the above and below described dielectric lens.

Another aspect relates to the use of the above and below described dielectric lens or the above described radar sensor for passenger monitoring in a vehicle.

Another aspect relates to the use of the above and below described dielectric lens or the radar sensor for measuring a fill level.

Further uses are for door opening sensors, radar sensors for drones, radar sensors for robots and sensors for life sign monitoring in medical applications, such as respiration or pulse.

These and other aspects of the invention will become apparent from and elucidated with reference to the embodiments described hereinafter.

The illustration in the drawings is schematically. In different drawings, similar or identical elements are provided with the same reference numerals.

### Brief description of the figures

Fig. 1 shows a radar sensor.
Fig. 2A shows a sectional view of dielectric lens according to an embodiment.
Fig. 2B shows a different view of the dielectric lens of Fig. 2A.
Fig. 3 shows a radar sensor according to an embodiment.
Fig. 4 shows a dielectric lens with a chip according to an embodiment.
Fig. 5 shows a dielectric lens with a chip according to another embodiment.

### Detailed description of embodiments

The invention is related to integrated circuits for radar and/or communication applications. The radiating device is implemented as a radar chip and radiates and/or receives high frequency electromagnetic signals using on-chip integrated antennas or an antenna in package. The electromagnetic signals have a high frequency in the Gigahertz or Terahertz range.

Antenna performance is improved by a shaped piece of dielectric material collecting radiated energy from antenna(s) and redirecting the energy to desired direction.

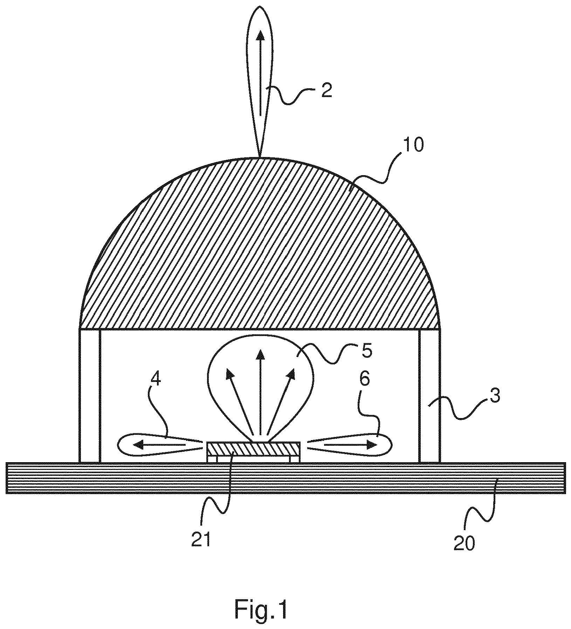

Fig. 1 shows a radar sensor. A radiating device 21 is placed at a printed circuit board (PCB) 20 to connect it to a power supply and other signals. The radiating device 21 is a miniaturized radar or communication device that has one or more chip-integrated antennas or an antenna in package that radiates in different directions for transmission and/or reception. The main lobe 5 radiates in direction of the dielectric lens 10 and the lens 10 is focussing the radiation in desired direction (see focused beam 2) to increase the range.

The chip-integrated antennas and antennas in package are usually planar structures utilizing the planar chip metal layers or planar metal layers within the package. This may lead to side-lobes 4, 6 radiating in directions parallel to the surface of the radar or communication device and parallel to the PCB, towards supporting walls 3.

This undesired radiation 4, 6 represents lost energy and can lead to unwanted ghost targets in a radar system by generating reflections from objects in directions outside the desired field of view.

The dielectric lens consists of plastic material with relative dielectric constant around εᵣ = 3. This corresponds to a refractive index of 1.7.

The radiation of the main lobe 5 coming out of the compact radiating device has a wide opening angle because of the small size of the chip-integrated antenna or the antenna in package. This radiation reaches the planar part of the lens and penetrates the lens material. At the interfaces of the lens, the radiation is refracted according to the rules of electromagnetism resulting in a focused beam in a direction away from the lens 10 towards the object to be observed.

The radiation of the side lobes in Fig.1 is directed parallel to the PCB and does not enter the lens. Consequently, it represents lost energy.

Another problem with this lens arrangement results from the difficult alignment process of the lens. The lens has to be placed directly above the radiating device with the lens-centre aligned to the location of the antenna within the radiating device. The lens is fixed by several rods fixed on PCB at the one side and attached to the lens at the other side. This construction represents a cost driver and may lead to loss of radar-performance due to misalignment issues.

The dielectric lens may be formed on a resin package near the antenna. The lens is formed together with the process of packaging (encapsulation) of the chip. The same resin material is used for package and for the lens. Completely different requirements may exist for packaging material and for the lens. A common resin material may have to be used for package and lens and this may influence the performance of the device.

Another drawback in mass-production is the loss of flexibility. The geometry is defined by the package geometry and new requirements from customers cannot be taken into account. Another drawback is the problem with the side-lobes that will not be suppressed with the package.

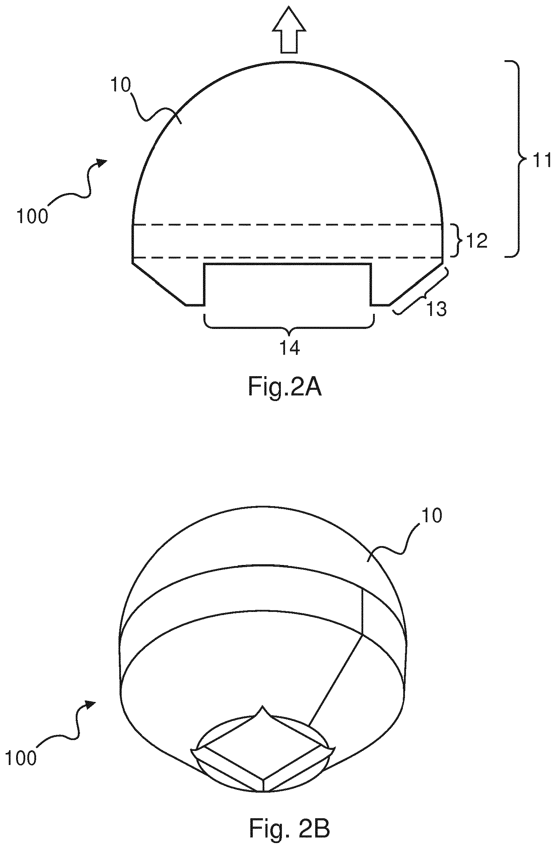

The following figures show improved embodiments. According to the embodiments depicted in Figs. 2A, 2B, 3, 4 and 5, a dielectric lens is provided, which is capable to self-align the lens with respect to the radiating device during assembly. The lens is configured to provide a mirror for collecting the side-lobe beam and to redirect the side-lobe beam to the desired direction for improved wireless and radar performance. One embodiment provides a dielectric lens comprising of three main portions, wherein the top portion (focussing part) 11 is shaped to form the radar beam according to desired parameters, the bottom portion (mirror part) 13 redirects the side lobes into a desired direction and the recess portion (construction part) 14 provides means for alignment of the lens to the radiating device especially to the antenna integrated in radiating device.

By the above described structure and arrangement, it becomes possible to focus the radar beam to a narrow or wide opening angle according to the radar requirements. It also becomes possible to increase the antenna efficiency by collecting the energy from side lobes and it becomes possible, during assembly process, to easily align the lens with the radiating device, resulting in low-cost manufacturing and assembly.

In the above described dielectric lens construction, the radiating device is soldered to PCB and the lens will be glued directly to the radiating device.

Another preferred embodiment provides a wireless communication device comprising the above described dielectric lens.

Use of the dielectric lens together with the radiating device can increase the range of a radar system or wireless system by forming the radar beam. It may also reduce malfunctions of the system.

The dielectric lens 10 shown in Figs. 2A and 2B comprises three main parts, wherein the focussing part 11 consists of a round shape preferably in form of a half-sphere with an additional cylindrical region 12. The focussing part can have an ellipsoid shape as well or a shape similar to this.

The mirror part 13 is a slanting section, for example with an angle of 45 degrees to the propagation direction of the main lobe. The "construction part" 14 is a recess at the bottom side of the lens adopted to the size of the radiating device.

Fig.2B shows the lens in a 3D view.

The dielectric lens 10 shown in Figs 2A and 2B, when compared to the dielectric lens shown in Fig. 1, has additional functional elements.

Besides the focussing part 11, which comprises a round shape, for example in form of a half-sphere, and, optionally, an additional cylindrical region 12, there is a mirror part 13 with a slanting section intended to redirect the radiation energy coming from the side lobes from radiating device towards the intended direction indicated in Fig. 2A and there is a construction part 14 consisting of a recess at the bottom side of the lens adopted to the size of the radiating device 21.

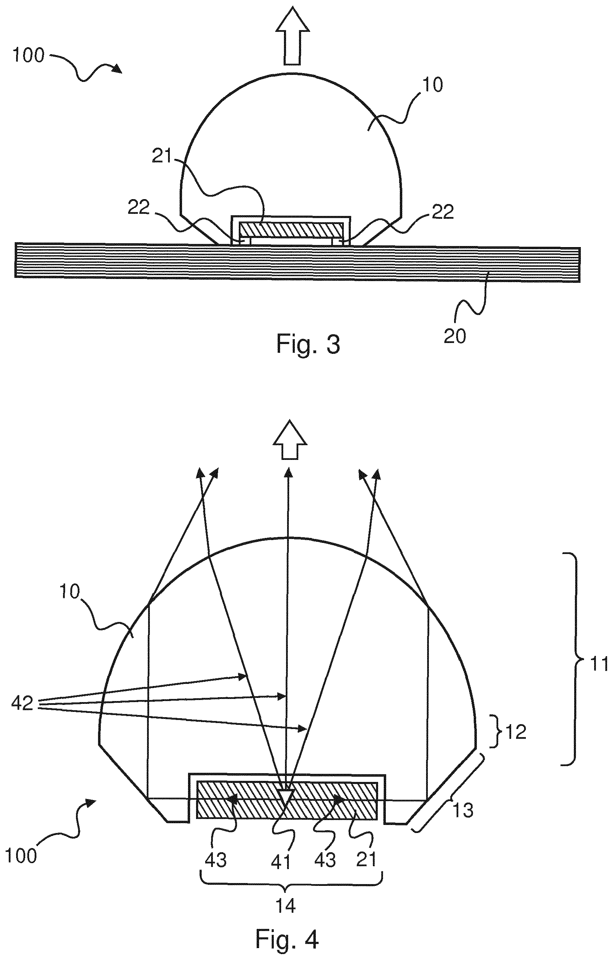

Fig. 3 shows the dielectric lens 10 mounted on a PCB 20 together with a radiating device 21 forming a radar sensor with improved performance. The radiating device 21 is electrically connected to PCB 20 by solder pads 22. The dielectric lens 10 is placed on top of the radiating device 21 and the recess of the dielectric lens encloses the radiating device 21. This arrangement facilitates the assembly process for the complete radar sensor because it enables self-alignment of the dielectric lens 10 with respect to the radiating device 21.

The dielectric lens 10 is glued to the radiating device 21 and it can be glued to the PCB 20. Even easier mounting can be obtained by modifying the recess of the construction part 14 with slanting side-walls.

Fig. 4 shows a dielectric lens together with a radiating device 21, and also an indication of the position of the antenna 41 inside the radiating device 21. The radiating device 21 comprises a Silicon chip with an integrated antenna 41 and a transparent package, for example consisting of resin. The radiating device 21 can also be a Silicon chip assembled in flip-chip technology. Thus, there is no package around the chip at all and the antenna is radiating into the dielectric lens 10 directly or through the silicon substrate. The dielectric lens 10 may be considered as the package of the chip because it protects the chip from external environment.

As indicated in Fig. 4, the origin of radiation (millimetre waves or Terahertz radiation) is the antenna 41 located inside or on the surface of the radiating device 21. The main direction of radiation 42 may be essentially perpendicular to the surface of the radiating device 21.

Because of planar technology usually used in semiconductor fabrication and packaging technologies, surface waves are exited leading to strong surface wave radiation 43 parallel to radiating device 21. This surface wave radiation 43 is reflected at mirror part 13. The mirror part 13 will reflect the surface wave radiation 43 because of the large difference in refractive index between dielectric lens material and air. The reflection properties can be enhanced by metallization of the surface of dielectric lens 10. However, in most of the cases, this is not required.

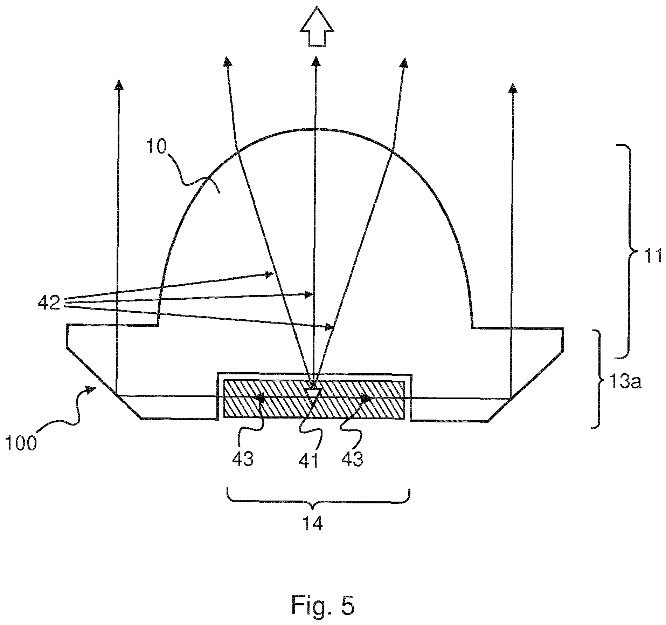

Fig. 5 shows another geometry of dielectric lens together with a radiating device 21 with indication of the position of the antenna 41 inside the radiating device 21. The mirror part 13a is arranged around the focussing part 11 to ensure that the surface wave radiation 13a is mirrored in perpendicular direction.

It should be noted that the term "comprising" does not exclude other elements or steps and the "a" or "an" does not exclude a plurality and that a single processor or system may fulfill the functions of several means or units recited in the claims. Also elements described in association with different embodiments may be combined. It should be also noted that the term "chip" can be a single Silicon chip e.g. in flip-chip configuration, but does not exclude configurations with Silicon chip combined with other semiconducting material.

It should also be noted, that any reference signs in the claims shall not be construed as limiting the scope of claims.

## Claims

1. A dielectric lens (10), comprising a silicon chip with an integrated antenna (41), configured to focus electromagnetic radiation generated and emitted by the chip, wherein the dielectric lens comprises a lens body with a top portion (11) configured to focus electromagnetic main lobe radiation emitted by the chip and a bottom portion having a recess (14) adapted to the size of the chip and configured to receive the chip, wherein the dielectric lens (10) is placed on top of the chip and the recess (14) of the lens encloses the chip;
wherein the dielectric lens (10) is fixed to the chip with non-conducting glue or by a clip mechanism.

2. The dielectric lens according to claim 1,
wherein the bottom portion comprising a mirror (13) arranged around the recess (14), configured to focus electromagnetic side lobe radiation (5, 42) emitted by the chip.

3. The dielectric lens according to claim 2,
wherein the mirror (13) has a conical surface with an angle of about 45 degrees to the longitudinal axis of the dielectric lens.

4. The dielectric lens according to claim 2,
wherein the mirror (13) has a parabolic surface.

5. The dielectric lens according to one of claims 2 to 4,
wherein the mirror (13) comprises a metal layer on the mirror surface.

6. The dielectric lens according to one of the preceding claims,
wherein the recess (14) of dielectric lens (10) comprises slanting side-walls.

7. The dielectric lens according to one of the preceding claims,
wherein the lens body has a rotational symmetry.

8. The dielectric lens according to one of the preceding claims,
wherein the dielectric lens (10) has a matching layer on top of the top portion (11).

9. The dielectric lens according to one of the preceding claims, further comprising:
a printed circuit board (20);
wherein the chip is arranged on the printed circuit board (20).

10. Radar sensor (100), comprising:
a dielectric lens (10) according to one of the preceding claims.

11. A transmitter, receiver or transceiver (100), configured for a mobile communications network, comprising:
a dielectric lens (10) according to one of claims 1 to 9.

12. Use of a dielectric lens according to one of claim 1 to 9 or a radar sensor according to claim 10 for passenger monitoring in a vehicle.

13. Use of a dielectric lens (10) according to one of claim 1 to 9 or a radar sensor (100) according to claim 10 for measuring a fill level or for measuring thickness of dielectric material.

## Patentansprüche

1. Dielektrische Linse (10), aufweisend einen Siliziumchip mit einer integrierten Antenne (41), die so konfiguriert ist, dass sie elektromagnetische Strahlung, die von dem Chip erzeugt und emittiert wird, fokussiert,
wobei die dielektrische Linse einen Linsenkörper mit einem oberen Abschnitt (11), der so konfiguriert ist, dass er elektromagnetische Hauptkeulenstrahlung, die von dem Chip emittiert wird, fokussiert, und einem unteren Abschnitt mit einer Aussparung (14), die an die Größe des Chips angepasst ist und so konfiguriert ist, dass sie den Chip aufnimmt, aufweist, wobei die dielektrische Linse (10) oben auf dem Chip platziert ist und die Aussparung (14) der Linse den Chip umschließt;
wobei die dielektrische Linse (10) mit nichtleitendem Klebstoff oder durch einen Clip-Mechanismus an dem Chip befestigt ist.

2. Dielektrische Linse gemäß Anspruch 1,
wobei der untere Abschnitt aufweisend einen Spiegel (13), der um die Aussparung (14) herum angeordnet und so konfiguriert ist, dass er elektromagnetische Nebenkeulenstrahlung (5, 42), die von dem Chip emittiert wird, fokussiert.

3. Dielektrische Linse gemäß Anspruch 2,
wobei der Spiegel (13) eine konische Oberfläche mit einem Winkel von etwa 45 Grad zur Längsachse der dielektrischen Linse aufweist.

4. Dielektrische Linse gemäß Anspruch 2,
wobei der Spiegel (13) eine parabolische Oberfläche aufweist.

5. Dielektrische Linse gemäß einem der Ansprüche 2 bis 4,
wobei der Spiegel (13) eine Metallschicht auf der Spiegeloberfläche aufweist.

6. Dielektrische Linse gemäß einem der vorhergehenden Ansprüche,
wobei die Aussparung (14) der dielektrischen Linse (10) schräge Seitenwände aufweist.

7. Dielektrische Linse gemäß einem der vorangehenden Ansprüche,
wobei der Linsenkörper eine Rotationssymmetrie aufweist.

8. Dielektrische Linse gemäß einem der vorangehenden Ansprüche,
wobei die dielektrische Linse (10) eine Anpassungsschicht oben auf dem oberen Abschnitt (11) aufweist.

9. Dielektrische Linse gemäß einem der vorangehenden Ansprüche, ferner aufweisend:
eine Leiterplatte (20);
wobei der Chip auf der Leiterplatte (20) angeordnet ist.

10. Radarsensor (100), aufweisend:
eine dielektrische Linse (10) gemäß einem der vorangehenden Ansprüche.

11. Sender, Empfänger oder Transceiver (100), konfiguriert für ein mobiles Kommunikationsnetzwerk, aufweisend:
eine dielektrische Linse (10) gemäß einem der Ansprüche 1 bis 9.

12. Verwendung einer dielektrischen Linse gemäß einem der Ansprüche 1 bis 9 oder eines Radarsensors gemäß Anspruch 10 zur Passagierüberwachung in einem Fahrzeug.

13. Verwendung einer dielektrischen Linse (10) gemäß einem der Ansprüche 1 bis 9 oder eines Radarsensors (100) gemäß Anspruch 10 zur Messung eines Füllstands oder zur Messung der Dicke von dielektrischem Material.

## Revendications

1. Lentille diélectrique (10) comprenant une puce de silicium avec une antenne intégrée (41), configurée pour focaliser un rayonnement électromagnétique généré et émis par la puce, dans laquelle la lentille diélectrique comprend un corps de lentille avec une partie supérieure (11) configurée pour focaliser un rayonnement électromagnétique du lobe principal émis par la puce et une partie inférieure ayant un évidement (14) adapté à la taille de la puce et configuré pour recevoir la puce, dans laquelle la lentille diélectrique (10) est placée sur le dessus de la puce et l'évidement (14) de la lentille entoure la puce ;
dans laquelle la lentille diélectrique (10) est fixée à la puce avec une colle non conductrice ou par un mécanisme de pince.

2. Lentille diélectrique selon la revendication 1,
dans laquelle la partie inférieure comprend un miroir (13) disposé autour de l'évidement (14), configuré pour focaliser un rayonnement électromagnétique des lobes secondaires (5, 42) émis par la puce.

3. Lentille diélectrique selon la revendication 2,
dans laquelle le miroir (13) a une surface conique avec un angle d'environ 45 degrés par rapport à l'axe longitudinal de la lentille diélectrique.

4. Lentille diélectrique selon la revendication 2,
dans laquelle le miroir (13) a une surface parabolique.

5. Lentille diélectrique selon l'une des revendications 2 à 4,
dans laquelle le miroir (13) comprend une couche de métal sur la surface de miroir.

6. Lentille diélectrique selon l'une des revendications précédentes,
dans laquelle l'évidement (14) de la lentille diélectrique (10) comprend des parois latérales inclinées.

7. Lentille diélectrique selon l'une des revendications précédentes,
dans laquelle le corps de lentille a une symétrie de rotation.

8. Lentille diélectrique selon l'une des revendications précédentes,
dans laquelle la lentille diélectrique (10) a une couche d'adaptation au-dessus de la partie supérieure (11).

9. Lentille diélectrique selon l'une des revendications précédentes, comprenant en outre :
une carte à circuit imprimé (20) ;
dans laquelle la puce est disposée sur la carte à circuit imprimé (20).

10. Capteur radar (100), comprenant :
une lentille diélectrique (10) selon l'une des revendications précédentes.

11. Émetteur, récepteur ou émetteur-récepteur (100), configuré pour un réseau de communication mobile, comprenant :
une lentille diélectrique (10) selon l'une des revendications 1 à 9.

12. Utilisation d'une lentille diélectrique selon l'une des revendications 1 à 9 ou d'un capteur radar selon la revendication 10 pour la surveillance de passagers dans un véhicule.

13. Utilisation d'une lentille diélectrique (10) selon l'une des revendications 1 à 9 ou d'un capteur radar (100) selon la revendication 10 pour mesurer un niveau de remplissage ou pour mesurer une épaisseur de matériau diélectrique.
